(19) **Europäisches Patentamt**

**European Patent Office**

**Office européen des brevets**

(11) **EP 1 087 235 A1**

(12) **EUROPEAN PATENT APPLICATION**

(43) Date of publication:
28.03.2001 Bulletin 2001/13

(51) Int. Cl.[7]: **G01R 33/563**

(21) Application number: 00308012.4

(22) Date of filing: 14.09.2000

(84) Designated Contracting States:
**AT BE CH CY DE DK ES FI FR GB GR IE IT LI LU MC NL PT SE**
Designated Extension States:
**AL LT LV MK RO SI**

(30) Priority: 21.09.1999 US 400228
31.03.2000 US 540341

(71) Applicant:
**Marconi Medical Systems, Inc.
Highland Heights, Ohio 44143 (US)**

(72) Inventors:
• **Liu, Kecheng**
**Solon, OH 44139 (US)**
• **Lin, Jian**
**Solon, OH 44139 (US)**
• **Margosian, Paul M.**
**Lakewood, OH 44107 (US)**

(74) Representative: **Waters, Jeffrey**
**Marconi Intellectual Property**
**Waterhouse Lane**
**Chelmsford Essex CM1 2QX (GB)**

(54) **Magnetic resonance imaging**

(57) A black blood magnetic resonance angiogram is produced by exciting dipoles and repeatedly inverting the resonance to produce a series of magnetic resonance echoes. Early echoes are more heavily proton density weighted than later echoes, which are more heavily T2 weighted. The magnetic resonance echoes are received and demodulated into a series of data lines. The data lines are sorted between the more heavily proton density weighted data lines and T2 weighted data lines which are reconstructed into a proton density weighted image representation and a T2 weighted image representation. The proton density weighted and T2 weighted image representations are combined (90) to emphasize the black blood from the T2 weighted images and the static tissue from the proton density weighted image. The combination processor (90) scales (92) the PDW and T2W images to a common maximum intensity level. The PDW and T2W image representations are then combined, e.g. averaged, together (94) to form a combined or averaged image. An edge image (96) is computed from the T2W image and a threshold mask (98) is applied. The edge image (96) is combined (100) with the combined image (94) to form an edge enhanced image. Optionally, a minimum projection intensity algorithm (102) is applied to the enhanced image. Preferably, the enhanced image is a black blood magnetic resonance angiogram with emphasized blood vessel edges.

Fig. 3

**Description**

The present invention relates to the field of magnetic resonance imaging. It finds particular application in conjunction with black blood magnetic resonance angiography and may be described with particular reference thereto. It is to be appreciated, however, that the invention will also find application in conjunction with other types of angiography and other types of magnetic resonance imaging.

Measurement of blood flow, in vivo, is important for the functional assessment of the circulatory system. Angiography has become a standard technique for making such functional assessments. Magnetic resonance angiography (MRA) provides detailed angiographic images of the body in a non-invasive manner, without the use of contrast agents or dyes.

Traditionally, MRA methods can be divided into "white blood" and "black blood" techniques. In white blood angiographs or time of flight (TOF) angiographs, magnetic resonance signal from flowing blood is optimized, while signal from stationary blood or tissue is suppressed. This method has been problematic for a number of reasons. First, it is difficult to generate accurate images of the vascular system because the excited blood is constantly moving out of the imaging region. Also, blood vessels often appear more narrow because signal from the slow-flowing blood at the edges of the vessels is difficult to detect. Signal is reduced by complex blood flow behavior, such as pulsatility, vorticity, and acceleration in tight turns, causing signal void due to dephasing.

In contrast, black blood angiography methods utilize a flow-related signal void. The magnetic resonance signals from flowing blood are suppressed, while the signals from stationary blood and tissue are optimized. In other words, flowing blood is made to appear dark or black on the magnetic resonance image due to an absence or minimum of resonance signal emanating from the blood. The black blood method is typically preferable to the white blood method because it is easier to make flowing blood appear dark for the aforementioned reasons. In addition, blood vessels on a black blood angiograph appear larger because the slow-moving blood at the edges is clearly imaged. Also, the black blood MRA provides more detailed depiction of small vessels where blood flow is slower.

In black blood MRA, the flow-related signal void can be generated by using spoiling gradients, pre-saturation RF pulses, or defocused flowing spins. The first two means are mostly used in field echo (FE) style sequences while the latter one is typically used in spin echo (SE) style sequences, such as fast spin echo (FSE) sequences.

In the past, proton density weighted (PDW) FSE sequences have been used to acquire black blood angiography images. For an n-echo FSE sequence (n = 2, 4, . . ., 32, etc.) the first echo is oriented near the centre of k-space, the second echo is located in the adjacent segment, and so on working out from the centre. In such an arrangement of k-space data, PDW images are acquired. These images typically exhibit good background tissue depiction. However, slow-flowing dipoles are refocused by the subsequent 180° pulses contributing signal and resulting in "filling", i.e., black blood in the centre of arteries and veins and white or gray blood along the blood vessel walls, in capillaries, and in areas with slower moving blood. The filling effect leads to falsified vessel definition. While this problem may be resolved by using pre-saturation RF pulses, this comes at the cost of increasing patient magnetic field dose (SAR) which is very critical on a high field system ($\geq$ 1.5T).

Typically, black blood angiography images are processed using conventional minimum intensity projection algorithms. However, because minimum intensity projection algorithms enhance dark areas of signal void, it is difficult to distinguish dark vascular regions from dark background and/or cavities. In the past, the difficulty in distinguishing vascular and nonvascular dark regions has been resolved by using manually defined seed voxels, either vascular or nonvascular, as a starting point. From there, thresholding and connectivity criteria have been employed to selectively locate vascular signal voids. This image processing method is both slow and complicated, thus reducing ease and efficiency of black blood MRA applications. In addition, previous methods have not attempted to use two types of measurement, containing supplementary and complementary data, with different types of contrast.

In accordance with one aspect of the present invention, a method for generating a black blood magnetic resonance angiograph of a body portion includes exciting dipoles within a selected imaging region to produce magnetic resonance signals. A train of magnetic resonance echoes are induced after the excitation such that early echoes of the train are more heavily proton density weighted and later echoes are more heavily T2 weighted. The train of magnetic resonance echoes are phase and frequency encoded and received and demodulated into a series of data lines. The data lines are sorted between data lines from more heavily proton density weighted echoes and data lines from more heavily T2 weighted echoes. The more heavily proton density weighted data lines are reconstructed into a proton density weighted image representation, while the more heavily T2 weighted data lines are reconstructed into a T2 weighted image representation. The proton density weighted and T2 weighted image representations are combined to generated a combined image representation.

In accordance with a more limited aspect of the present invention, the combining step includes scaling the proton density weighted image representation and the T2 weighted image representation to a common maximum intensity level. The proton density weighted and T2 weighted image representations are averaged to form an averaged image representation. An edge enhanced image is computed from the T2 weighted image representation and the edge image representation is subtracted from the averaged image representation, forming an angiographic image representation.

In accordance with another aspect of the present invention, a magnetic resonance imaging system includes a magnet for generating a temporally constant magnetic field through an examination region. A radio frequency transmitter excites and inverts magnetic dipoles in the examination region to generate a train of magnetic resonance echoes. Gradient magnetic field coils and a gradient magnetic field controller generate at least phase and read magnetic field gradient pulses in orthogonal directions across the examination region. A receiver receives and demodulates the magnetic resonance echoes to produce a series of data lines. A sort processor sorts the data lines between proton density weighted data lines and T2 weighted data lines. An early echo volume memory stores proton density weighted data lines, while a late echo volume memory stores the T2 weighted data lines. An image processor reconstructs the proton density weighted data lines into a proton density weighted image representation and the T2 weighted data lines into a T2 weighted image representation. A combination processor combines the proton density weighted and T2 weighted image representations.

In accordance with a more limited aspect of the present invention, the combination processor includes a scaling processor which scales the proton density weighted and T2 weighted image representations to a common maximum intensity level. A processor combines the proton density weighted and T2 weighted image representations into a combined image representation. An edge image processor computes an edge image representation from the T2 weighted image representation. A processor combines the edge image representation and the combined image representation to form an edge enhanced image representation.

Ways of carrying out the invention will now be described in detail, by way of example, with reference to the accompanying drawings, in which:

FIGURES 1A and 1B taken together are a diagrammatic illustration of a magnetic resonance imaging system in accordance with the present invention;

FIGURE 2 illustrates one repeat of a preferred fast spin echo imaging sequence in accordance with the present invention; and

FIGURE 3 illustrates a diagrammatic illustration of a combination processor in accordance with the present invention.

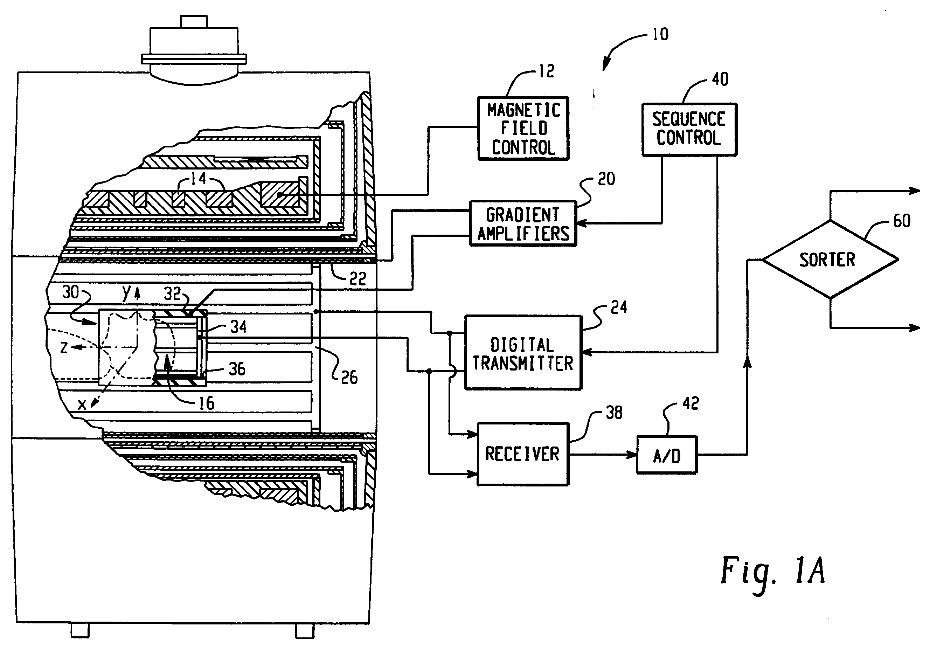

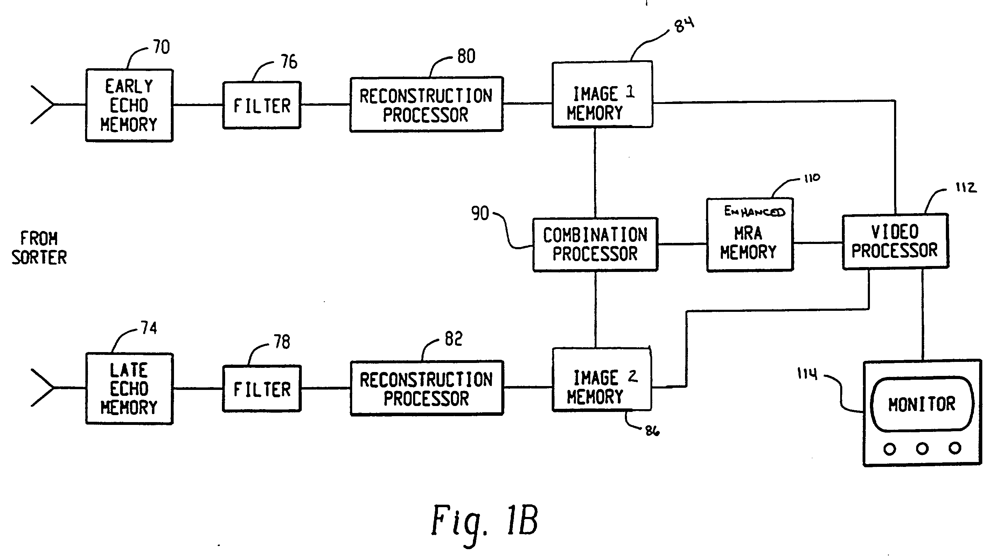

With reference to FIGURES 1A and 1B, a magnetic resonance imaging system 10 includes a main magnetic field control 12 which controls superconducting or resistive magnets 14 such that a substantially uniform, temporally constant main magnetic field is created along a z-axis through an examination region 16. Although a bore-type magnet is illustrated in FIGURE 1, it is to be appreciated that the present invention is equally applicable to open magnet systems. A magnetic resonance echo means applies a series of radio frequency (RF) and magnetic field gradient pulses to invert or excite magnetic spins, induce magnetic resonance, refocus magnetic resonance, manipulate magnetic resonance, spatially and otherwise encode the magnetic resonance, to saturate spins, and the like to generate magnetic resonance imaging and spectroscopy sequences.

More specifically, gradient pulse amplifiers 20 apply current pulses to selected ones or pairs of whole-body gradient coils 22 to create magnetic field gradients along x, y, and z-axes of the examination region 16. A digital radio frequency transmitter 24 transmits radio frequency pulses or pulse packets to a whole-body quadrature RF coil 26 to transmit RF pulses into the examination region. A typical radio frequency pulse is composed of a packet of immediately contiguous pulse segments of short duration which, taken together with each other and any applied gradients, achieve a selected magnetic resonance manipulation. The RF pulses are used to saturate, excite resonance, invert magnetization, refocus resonance, or manipulate resonance in selected portions of the examination region. For whole-body applications, the resonance signals are commonly picked up in quadrature by the whole body RF coil 26.

For generating images of limited regions of the subject, local coils are commonly placed contiguous to the selected region. For example, an insertable head coil 30 is inserted surrounding a selected brain region at the isocentre of the bore. The insertable head coil preferably includes local gradient coils 32 which receive current pulses from the gradient amplifiers 20 to create magnetic field gradients along x, y, and z-axes in the examination region within the head coil. A local quadrature radio frequency coil 34 is used to excite magnetic resonance and receive magnetic resonance signals emanating from the patient's head. Alternatively, a receive-only local radio frequency coil can be used for reception of resonance signals introduced by body coil RF transmissions. An RF screen 36 screens the RF signals from the RF head coil from inducing any currents in the gradient coils and the surrounding structures. The resultant radio frequency signals, whether picked up in quadrature by the whole-body RF coil 26, the local RF coil 34, or other specialized RF coils, are demodulated by a receiver 38, preferably a digital receiver.

A sequence control processor 40 controls the gradient pulse amplifiers 20 and the transmitter 24

to generate any of a plurality of magnetic resonance imaging and spectroscopy sequences, such as fast spin echo imaging, and other conventional sequences. For the selected sequence, the receiver **38** receives a plurality of data lines from a rapid succession of echoes following each RF excitation pulse. An analog-to-digital converter **42** converts each of the data lines to a digital format. The analog-to-digital converter **42** is disposed between the radio frequency receiving coil and the receiver **38** for digital receivers and is disposed down stream (as illustrated) from the receiver for analog receivers.

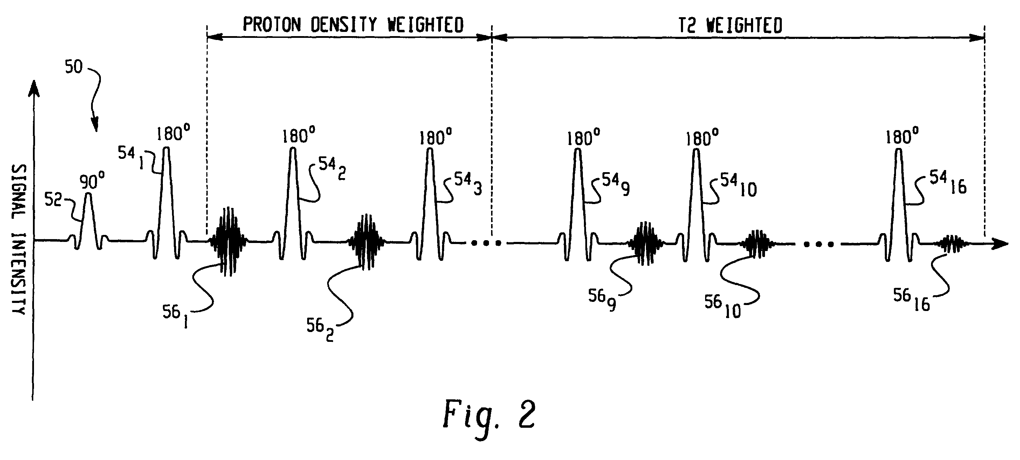

With reference to FIGURE 2 and continuing reference to FIGURES 1A and 1B, a fast spin echo (FSE) imaging sequence **50** commences with a radio frequency excitation pulse **52**, typically 90°. Following the RF excitation pulse, a series of 180° refocusing pulses are applied **54$_1$, 54$_2$, ..., 54$_{16}$**. The application of each refocusing pulse results in the generation of a magnetic resonance echo **56$_1$, 56$_2$, ..., 56$_{16}$**. While not shown in FIGURE 2, it is to be appreciated that slice-select gradient pulses, phase-encoding gradient pulses, read gradient pulses, and the like are also applied as is typical in a fast spin echo sequence.

In a preferred embodiment, the FSE has an echo train length (ETL) of sixteen which generates sixteen echoes following each of sixteen 180° refocusing pulses. In the embodiment of FIGURE 2, the first half of the ETL, preferably eight echoes, is reconstructed into a proton density weighted image (PDW), while the second half of the ETL, starting with the ninth echo, is reconstructed into a T2 weighted image.

Referring again to FIGURES 1A and 1B, the digital data lines are sorted by a sorter **60** between early echo data lines and late echo data lines. It will be appreciated that the first echo is the most heavily proton-density weighted or T1 weighted, while the last echo is the most heavily T2 weighted. The sorted radio frequency signals are stored into an early echo memory **70** and a late echo memory **74**. Optionally, echoes near the midpoint of the sequence can be channelled to both memories. The MR data lines are preferably passed through filters **76, 78**, such as a Blackman, Hanning, Hamming, or Gaussian filter. A pair of reconstruction processors **80, 82** (or a single time shared processor) reconstruct the data to form an electronic image representation. Reconstruction is preferably accomplished by a two-dimensional Fourier transform or other appropriate reconstruction algorithm. The image may represent a three-dimensional slab, a planar slice through the patient, an array of parallel planar slices, other three-dimensional volumes, or the like. The image representations are stored in image memories **84, 86**.

At this point in the imaging process, both a proton density weighted (PDW) image and a T2 weighted (T2W) volume image representation are stored in the image memories **84, 86**. Proton density weighted images typically provide better background and tissue depiction; while T2 weighted images typically provide better vessel depiction for a black blood technique.

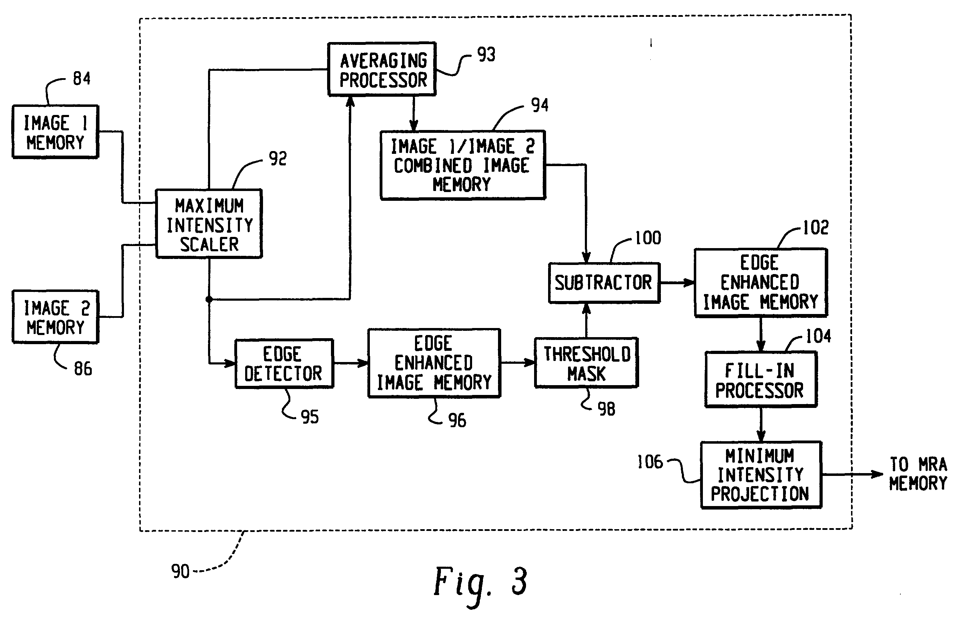

These two image representations are combined in image space by a combination processor **90**. The PDW image and T2W image can be combined using a variety of methods, such as thresholding, addition, and multiplication of the images. With reference to FIGURE 3 and continuing reference to FIGURES 1A and 1B, in one preferred embodiment, the combination processor **90** scales **92** the PDW and T2W images to the same maximum intensity level. In other words, the brightest point on the PDW image has the same intensity as the brightest point on the T2W image. From here, the T2W image signal is split. One branch of the T2W image signal is averaged together with the PDW image to make the background more homogeneous, preferably via a complex averaging processor **93**, to form an averaged or combined image which is stored in a PDW and T2W combined image memory **94**. It is to be appreciated that the complex averaging provides an enhanced signal-to-noise ratio (SNR). The other branch of the T2W image signal is processed by an edge detector or edge enhancement processor **95** in order to extract vessel edges, yielding an edge or gradient image which is stored in an edge image memory **96**. Preferably, the gradient image **96**, G, is produced by calculating the maximum directional derivative, i.e. second derivative, image from the T2W image and taking its absolute value within a 3 x 3 grid. In mathematical terms, the gradient is calculated as follows:

$$D_X = I(i+1,j) - I(i-1,j) \qquad (1)$$

$$D_Y = I(i,j+1) - I(i,j-1) \qquad (2).$$

From this, a maximum gradient, G, is calculated:

$$G \;=\; \frac{D_X^2 + D_Y^2}{\sqrt{D_X^2 + D_Y^2}} \;=\; \sqrt{D_X^2 + D_Y^2} \qquad (3).$$

In an alternate embodiment of the invention, a higher resolution derivative image is calculated by performing a 2-D Fourier transform of the T2W image, multiplying by $j\omega_x$ and $j\omega_y$, and reverse transforming. A threshold mask **98** is optionally applied to the maximum gradient, G, in order to removed any falsified gradient due to the noise level. The threshold is determined by:

$$I_{threshold} = \sqrt{2}(I_{noise} + \sigma_{noise}) \qquad (4).$$

This results in an image that is maximum black along the blood flow edges (typically about 2-4 pixels wide) and white everywhere else, including the centre of the blood flow. Of course, black and white can be reversed.

The final combined black blood angiography image or edge enhanced image, $I_{BB}$, is generated by combining the edge image and the averaged or combined image, preferably by subtracting the edge image from the averaged image, using a processor **100**, preferably a subtractor. Mathematically, $I_{BB}$ is given by:

$$I_{BB} = | (S_{PDW} + S_{T2W}) | -G_{max} ( |S_{T2W}|) \quad (5).$$

Subtraction of the edge image from the average image is performed using amplitude images so there are no phase problems between the edge image and the averaged image. Those skilled in the art will appreciate that imaging difficulty may arise with blood vessels which circulate blood in directions perpendicular to the imaging plane. It is to be appreciated that subtracting the edge image from the average image drives the edges of the vessels black for 2-4 pixels in the combined image. Therefore, the vessels of most interest in angiography examinations, i.e., vessels having diameters on the order of 5-6 pixels wide, appear black. Larger diameter vessels which cross the imaging plane, i.e., vessels having diameters of 10-15 pixels wide, may appear as a black annular ring with a light centre. The edge enhanced or combined image is stored in an edge enhanced image memory **102**. Optionally, the centres of the annular rings are filled in black by a fill-in processor **104** using a number of conventional techniques such as minimum intensity projection, region growing, and the like.

After calculation of the combined black blood image, a conventional minimum intensity projection algorithm **106** is optionally applied to the combined black blood image in order to enhance signal voids representative of blood vessels. It is to be appreciated that the above image combining technique is applicable to a variety of other imaging applications, such as processing 2-D and 3-D data, processing field and/or spin echoes, processing two or more source images, combining black-blood and white-blood MRA images to form an arteriogram and venogram, and the like. Further, the preferred image combining technique may be used to combine various complex image representations which have different preferential attributes in order to produce an enhanced combination image.

In another embodiment of the combination process, the black blood portions of the T2 images are combined with the tissue image portions of the PDW images. More particularly, the T2W images are thresholded to identify voxels that are sufficiently black/dark gray that they indicate blood. Voxels blacker than the threshold are taken from the T2W image representation and voxels whiter than the threshold are taken from the PDW image representation.

Regardless of the combination process employed, the combination of the PDW image and T2W image result in the generation of a black blood angiograph which is stored in an MRA memory **110**. A video processor **112** under operator control selects data from any or all of the PDW image memory **84**, the T2W image memory **86** and the MRA image memory **110**. In one preferred mode, the video processor selects corresponding slices from all three image memories for concurrent, side-by-side display on a monitor **114** to provide a human-readable display.

It is to be appreciated that the combination process of the preferred embodiment may be employed to combine any two or more complex image representations, where each complex image representation has different preferential attributes. For example, multiple complex PDW, T2W, and T1W image representations, each complex image representation containing supplementary and complementary information, may be combined by the preferred combination method.

One advantage of the described methods of rendering vascular morphology in MRI with multiple contrast acquisition for black-blood angiography is that it is more scan time efficient. Another advantage is that it results in improved signal-to-noise ratio. Another advantage is that multiple contrast images, such as a proton density weighted image, a T2 weighted image, and a black blood angiogram, are acquired from a single scan. Another advantage is that it leads to more accurate vascular morphology and better depiction of hyperfine vessels. Another advantage is that it eliminates misregistration error between proton density weighted images and T2 weighted images. Yet another advantage is that it reduces the SAR level.

**Claims**

1. A method for generating a black blood magnetic resonance angiograph of a body portion, said method comprising:

   (a) exciting dipoles **(52)** within a selected imaging region **(16)** to produce magnetic resonance signals;

   (b) inducing a train of magnetic resonance echoes **($56_1$,..., $56_{16}$)** after the excitation, early echoes **($56_1$,..., $56_8$)** of the train being more heavily proton density weighted and later echoes **($56_9$,..., $56_{16}$)** being more heavily T2 weighted;

   (c) phase and frequency encoding **(40)** the train of magnetic resonance echoes;

   (d) receiving and demodulating **(38)** the train of magnetic resonance echoes into a series of data lines;

(e) sorting **(60)** the data lines between data lines from more heavily proton density weighted echoes and data lines from more heavily T2 weighted echoes;

(f) reconstructing **(80, 82)** the more heavily proton density weighted data lines into a proton density weighted image representation and the more heavily T2 weighted data lines into a T2 weighted image representation; and

(g) combining **(90)** the proton density weighted image representation and the **T2** weighted image representation to generate a combined image representation.

2. A method as claimed in claim 1, wherein the combining step **(90)** includes: prior to the combining step **(90)**, scaling **(92)** the proton density weighted image representation and the T2 weighted image representation to a common maximum intensity level; computing an edge enhanced image **(95, 96)** from the T2 weighted image representation; and combining **(100)** the edge enhanced image and the combined image representations to form an angiographic image representation.

3. A method as claimed in claim 2, said method further comprising: performing a minimum intensity projection enhancement **(106)** on the angiographic image representation.

4. A method as claimed in claim 2 or claim 3, wherein computing the edge enhanced image includes: calculating **(95)** a maximum directional derivative image representation based on the T2 weighted image representation; and filtering each pixel value of the derivative image grid of surrounding pixel values.

5. A method as claimed in any one of claims 2 to 4, further including: selecting corresponding portions of the proton density weighted image representation, the T2 weighted image representation, and the angiographic image representation; and converting **(112)** the selected image representation portions into a concurrent, side-by-side human-readable display **(114)** of the selected portions.

6. A method as claimed in any one of claims 2 to 5, further including: computing **(95)** a blood vessel edge enhanced image representation; and combining **(100)** the proton density and edge enhanced image representations to generate a vessel edge enhanced angiographic image representation.

7. A method as claimed in claim 1, wherein the combining step **(90)** includes: scaling **(92)** the proton density weighted image representation and the T2 weighted image representation to a common maximum intensity level; averaging **(93)** the proton density and T2 weighted image representations, forming an averaged image; computing **(95)** an edge image from the T2 weighted image representation; and subtracting **(100)** the edge image from the averaged image representations, forming an angiographic image representation.

8. A method as claimed in claim 7, wherein computing the edge image includes: calculating **(95)** a maximum directional derivative image representation based on the T2 weighted image representation; and filtering each pixel value of the derivative image representation of surrounding pixel values.

9. Magnetic resonance imaging system which includes a magnet **(14)** for generating a temporally constant magnetic field through an examination region **(16)**, a radio frequency transmitter **(24)** for exciting and inverting magnetic dipoles in the examination region **(16)** to generate a train of magnetic resonance echoes **($56_1$,..., $56_{16}$)**, and gradient magnetic field coils **(22)** and a gradient magnetic field controller **(40)** for generating at least phase and read magnetic field gradient pulses in orthogonal directions across the examination region **(16)**, a receiver **(38)** for receiving and demodulating the magnetic resonance echoes **($56_1$,..., $56_{16}$)** to produce a series of data lines, the system **(10)** further comprising: a sort processor **(60)** for sorting data lines between proton density weighted data lines and T2 weighted data lines; an early echo volume memory **(70)** for storing the proton density weighted data lines; a late echo volume memory **(72)** for storing the T2 weighted data lines; an image processor **(80, 82)** for reconstructing the proton density weighted data lines into a proton density weighted image representation and the T2 weighted data lines into a T2 weighted image representation; and a combination processor **(90)** for combining the proton density weighted and the T2 weighted image representations.

10. Magnetic resonance imaging system as claimed in claim 9, wherein the combination processor includes: a scaling processor **(92)** which scales the proton density weighted and T2 weighted image representations to a common maximum intensity level; a processor **(93)** which combines the proton density weighted and T2 weighted image representations into a combined image representation; an edge image processor **(95)** which computes an edge image representation from the T2 weighted image representation; and a processor **(100)** which combines the edge image representation and the combined image representation to form an edge

**EP 1 087 235 A1**

enhanced image representation.

11. Magnetic resonance imaging system as claimed in claim 9, wherein the combination processor **(90)** includes: a scaling processor **(92)** which scales the proton density weighted and T2 weighted image representations to a common maximum intensity level; an averaging processor **(93)** which averages the proton density weighted and T2 weighted image representations into an averaged image representation; an edge image processor **(95)** which computes an edge image representation from the T2 weighted image representation; and a subtractor **(100)** which subtracts the edge image representation from the averaged image representation to from an edge enhanced image representation.

12. Magnetic resonance imaging system as claimed in claim 11, wherein the edge image processor **(95)** calculates a second derivative image based on the T2 weighted image representation.

Fig. 1A

*Fig. 1B*

EP 1 087 235 A1

Fig. 2

Fig. 3

EP 1 087 235 A1

**European Patent Office**

## EUROPEAN SEARCH REPORT

Application Number

EP 00 30 8012

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X<br><br>A | EP 0 296 834 A (PICKER INTERBATIONAL, INC.) 28 December 1988 (1988-12-28)<br><br>* column 1, line 3 - line 11 *<br>* column 1, line 51 - column 3, line 39 *<br>* column 4, line 32 - column 8, line 10 *<br>* figures 1,2 * | 1,2,5,<br>9-11<br>3,4,6-8,<br>12 | G01R33/563 |
| X<br><br>A | D.C. NOLL: "Variable-Averaging RARE" MAGNETIC RESONANCE IN MEDICINE, vol. 31, 1984, pages 323-327, XP000434369<br><br>* the whole document * | 1,9<br><br>2-8,<br>10-12 | |
| A | US 5 070 876 A (G.A. WRIGHT) 10 December 1991 (1991-12-10)<br>* column 2, line 50 - column 7, line 11 *<br>* figures 1,2 * | 1-12 | |
| A | US 5 257 626 A (N.J. PELC ET AL.) 2 November 1993 (1993-11-02)<br>* column 4, line 54 - column 7, line 20 * | 1,9 | TECHNICAL FIELDS SEARCHED (Int.Cl.7)<br><br>G01R |

The present search report has been drawn up for all claims

| Place of search | Date of completion of the search | Examiner |
|---|---|---|
| THE HAGUE | 14 December 2000 | Volmer, W |

EPO FORM 1503 03.82 (P04C01)

**ANNEX TO THE EUROPEAN SEARCH REPORT
ON EUROPEAN PATENT APPLICATION NO.**　　　EP 00 30 8012

This annex lists the patent family members relating to the patent documents cited in the above-mentioned European search report.
The members are as contained in the European Patent Office EDP file on
The European Patent Office is in no way liable for these particulars which are merely given for the purpose of information.

14-12-2000

| Patent document cited in search report | | Publication date | Patent family member(s) | | Publication date |
|---|---|---|---|---|---|
| EP 296834 | A | 28-12-1988 | DE | 3855288 D | 20-06-1996 |
| | | | DE | 3855288 T | 19-09-1996 |
| | | | US | 4833407 A | 23-05-1989 |
| | | | US | 4881033 A | 14-11-1989 |
| US 5070876 | A | 10-12-1991 | NONE | | |
| US 5257626 | A | 02-11-1993 | US | 5195525 A | 23-03-1993 |
| | | | US | 5257625 A | 02-11-1993 |
| | | | DE | 69130975 D | 15-04-1999 |
| | | | DE | 69130975 T | 08-07-1999 |
| | | | EP | 0488496 A | 03-06-1992 |
| | | | ES | 2131505 T | 01-08-1999 |
| | | | JP | 6142079 A | 24-05-1994 |

EPO FORM P0459

For more details about this annex : see Official Journal of the European Patent Office, No. 12/82